# EUROPÄISCHE PATENTANMELDUNG

(11) **EP 1 217 743 A2**
(43) Veröffentlichungstag der Anmeldung: **26.06.2002**
(21) Anmeldenummer: 01123124.8
(22) Anmeldetag: 27.09.2001
(51) Int. Cl.: H03K 17/95, H03K 17/955

(54) **Berührungslose Schalteinrichtung**

(30) Priorität: 22.12.2000 DE 10064510
(71) Anmelder: Valeo Schalter und Sensoren GmbH, 74321 Bietigheim-Bissingen (DE)
(72) Erfinder: Barbulescu, Virgil, 94410 Saint Maurice (FR); Gross, Michael, 74226 Nordheim (DE)
(74) Vertreter: Dreiss, Fuhlendorf, Steimle & Becker

(57) **Zusammenfassung**

Die Erfindung betrifft eine Schalteinrichtung zur Erzeugung und Auswertung eines Schaltsignals.

Die Erfindung kennzeichnet sich dadurch, dass die Einrichtung wenigstens einen berührungslos beeinflussbaren, aufgrund der Beeinflussung seinen Widerstandswert ändernden Widerstand, einen in den Umgebungsbereich des Widerstandes bewegbaren und damit den Widerstand beeinflussenden Aktor sowie eine dem Widerstand nachgeschaltete, den Widerstandswert erfassende Auswerteeinheit aufweist, wobei durch Bewegen des Aktors in den Umgebungsbereich des Widerstandes der Widerstand seinen Widerstandswert ändert und die Auswerteeinheit die Widerstandswertänderung auswertet.

## Beschreibung

Die Erfindung betrifft eine Schalteinrichtung zur Erzeugung und Auswertung eines Schaltsignals. Die Erfindung betrifft außerdem ein Verfahren zur Erzeugung und Auswertung eines Schaltsignals.

Herkömmliche, bekannte Schalteinrichtungen weisen beispielsweise mechanische Schleifkontakte auf. Schleifkontakte werden hierbei über Kontaktflächen einer Leiterplatte bewegt. Je nach Stellung eines Betätigungselements einer derartigen Schalteinrichtung verbinden die Schleifkontakte verschiedene Kontaktstellen der Leiterplatte miteinander. Durch ein Verbinden der entsprechenden Kontaktstellen miteinander werden Schaltsignale gegeben. Derartige Schaltsignale können von beispielsweise einer zentralen Steuereinheit ausgewertet werden und einen dem Schaltsignal zugeordneten Vorgang einleiten.

Derartige Schalteinrichtungen sind beispielsweise im Kraftfahrzeugbau in vielfältiger Art und Weise bekannt. Die Schalteinrichtungen können beispielsweise als Kippschalter, Tastschalter, Schwenkschalter, Drehschalter o.dgl. ausgebildet sein.

Derartige, bekannte Schalteinrichtungen weisen allerdings den Nachteil auf, dass sie aufgrund des mechanischen Kontaktes zwischen einem Kontaktstück und einer Leiterplatte einem Verschleiß an den Kontaktflächen ausgesetzt sind. Weiterhin sind hochwertige Kontaktflächen nur mit hochwertigen Materialien, wie beispielsweise Silber oder Gold, zu realisieren.

Der Erfindung liegt deshalb die Aufgabe zugrunde, eine Schalteinrichtung sowie ein Verfahren der eingangs beschriebenen Art weiterzubilden, welche keinem Verschleiß unterliegen. Dennoch soll eine funktionssichere Erzeugung und Auswertung eines Schaltsignals gewährleistet sein.

Diese Aufgabe wird bei einer Schalteinrichtung der eingangs genannten Art erfindungsgemäß dadurch gelöst, dass die Einrichtung wenigstens einen berührungslos beeinflussbaren, aufgrund der Beeinflussung seinen Widerstandswert ändernden Widerstand, einen in den Umgebungsbereich des Widerstands bewegbaren und damit den Widerstand beeinflussenden Aktor sowie eine dem Widerstand nachgeschaltete, den Widerstandswert erfassende Auswerteeinheit aufweist, wobei durch Bewegen des Aktors in den Umgebungsbereich des Widerstandes der Widerstand seinen Widerstandswert ändert und die Auswerteeinheit die Widerstandsänderung auswertet.

Eine derartige Schalteinrichtung hat insbesondere den Vorteil, dass aufgrund des berührungslos beeinflusbaren Widerstandes kein Verschleiß zwischen dem Aktor und dem entsprechenden Widerstand erfolgen kann. Das durch Bewegen des Aktors in den Bereich des beeinflussbaren Widerstandes erzeugte Schaltsignal wird konstant mit gleicher Qualität generiert. Eine Abnutzung sowohl des Aktors also auch des beeinflussbaren Widerstandes aufgrund einer häufigen Erzeugung von Schaltsignalen kann erfindungsgemäß nicht stattfinden.

Außerdem kann bei einer erfindungsgemäßen Schalteinrichtung auf versilberte oder vergoldete Kontaktflächen auf einer Leiterplatte verzichtet werden.

Entscheidender Vorteil der erfindungsgemäßen Schalteinrichtung gegenüber dem bekannten Stand der Technik ist demnach, dass die erfindungsgemäße Schalteinrichtung das Schaltsignal berührungslos generiert.

Eine besonders bevorzugte Ausführungsform der Erfindung kennzeichnet sich dadurch, dass wenigstens zwei Widerstände vorhanden sind, dass einer der Widerstände als Referenzwiderstand und wenigstens ein weiterer Widerstand als von dem Aktor beeinflussbarer Widerstand ausgebildet ist, wobei die Auswerteeinheit durch Vergleich der Ausgangssignale des Referenzwiderstandes und des wenigstens einen beeinflussbaren Widerstandes ein Schaltsignal auswertet. Durch den Referenzwiderstand kann ein sich von dem Referenzwiderstand unterscheidendes Schaltsignal von der Auswerteeinheit ausgewertet werden. Dabei können insbesondere aufgrund der Beeinflussung des entsprechenden Widerstandes Widerstandswertänderungen auf einfache Art und Weise erfasst und ausgewertet werden.

Erfindungsgemäß kann weiterhin vorgesehen sein, dass der wenigstens eine beeinflussbare Widerstand ein mit Wechselstrom beaufschlagter frequenzabhängiger Widerstand ist. Ein derartiger frequenzabhängiger Widerstand eignet sich insbesondere, um von einem Aktor beeinflusst zu werden und hierbei seinen Widerstandswert zu ändern.

Eine besonders bevorzugte, erfindungsgemäße Ausgestaltung der Erfindung kennzeichnet sich dadurch, dass ein Oszillator, ein dem Oszillator nachgeschalteter erster frequenzabhängiger Widerstand (Referenzwiderstand) und ein dem Oszillator nachgeschalteter, zu dem ersten Widerstand parallel angeordneter Inverter vorgesehen ist, wobei dem Inverter ein zweiter frequenzabhängiger Widerstand (beeinflussbarer Widerstand) nachgeschaltet ist, dass dem ersten Widerstand und dem zweiten Widerstand ein Addierer, der die Ausgangssignale der beiden Widerstände addiert und eine Auswertelogik, die aufgrund eines sich ändernden Ausgangssignals des Addierers aufgrund der kontaktlosen Beeinflussung eines der beiden Widerstände durch den Aktor, ein Schaltsignal auswertet, nachgeschaltet ist. Eine derartige Schalteinrichtung hat den Vorteil, dass auf funktionssichere Art und Weise ein Schaltsignal erzeugt und ausgewertet werden kann. Aufgrund der Addition der beiden Ausgangssignale der beiden parallel zueinander angeordneten Widerstände kann vorteilhafterweise auf einfache Art und Weise eine Widerstandsänderung eines der beiden Widerstände aufgrund der Beeinflussung durch den Aktor erfasst und ausgewertet werden. Dabei ist es nicht entscheidend, welcher der beiden Widerstände der beeinflussbare Widerstand ist.

Hierbei hat sich als frequenzabhängiger Widerstand insbesondere ein induktiver Widerstand als geeignet erwiesen. Für einen derartigen Widerstand kommt als Aktor ein ferromagnetisches Metall in Betracht.

Andererseits ist auch denkbar, dass der frequenzabhängige Widerstand ein kapazitiver Widerstand ist und der Aktor ein Isolator mit insbesondere einer hohen Permittivitätszahl ist. Insbesondere eine Permittivitätszahl von εᵣ ca. 3 hat sich als günstig gezeigt.

Bei einer weiteren, ebenfalls besonders günstigen Ausführungsform der Erfindung weisen die Widerstände eine identische Widerstandscharakteristik auf. Dies hat den Vorteil, dass bei unbeeinflusstem Widerstand das Ausgangssignal des Addierers null ist. Die beiden Ausgangssignale der Widerstände heben sich aufgrund des einen invertierten Signales vollständig auf. Bei Beeinflussung von wenigstens einem Widerstand ist das Ausgangssignal des Addierers ungleich null, da sich dann die Ausgangssignale der einzelnen Widerstände nicht vollständig aufheben. Hierdurch kann eine sehr einfache und dennoch sehr genaue Bestimmung des Schaltsignals erfolgen.

Erfindungsgemäß ist auch denkbar, dass mehrere unterschiedliche, verschiedenen Schaltsignalen zuordenbare Aktoren vorhanden sind, welche den Widerstandswert des beeinflussbaren Widerstandes unterschiedlich ändern, wobei die Auswerteeinheit aufgrund der jeweiligen Widerstandsänderung feststellt, durch welchen Aktor die Widerstandsänderung erfolgte und so die unterschiedlichen Schaltsignale auswertet. Vorteil einer derartigen Schalteinrichtung ist, dass über nur einen beeinflussbaren Widerstand die Bewegung von verschiedenen Aktoren in die Umgebung des Widerstandes bestimmt werden kann. Übere eine Differenziereung der verschiedenen Ausgangssignale kann die Auswerteeinheit dem jeweiligen, betätigten Aktor eine entsprechende Schaltung zuordnen.

Zum Bewegen des Aktors kann erfindungsgemäß vorteilhafterweise vorgesehen sein, dass die Schaltereinheit ein Betägtigungselement aufweist. Das Betätigungselement kann hierbei mittel- oder unmittelbar mit dem Aktor gekoppelt sein.
Zur ortsfesten Anordnung der Widerstände kann die Schaltereinheit vorteilhafterweise eine Leiterplatte aufweisen.

Erfindungsgemäß ist ebenfalls denkbar, dass die Schaltereinheit als Fahrzeugschalter ausgebildet ist. Insbesondere Fahrzeugschalter unterliegen aufgrund ihrer häufigen Betätigung einem Verschleiß. Eine erfindungsgemäße Schaltereinheit hat den Vorteil, dass sie verschleißfrei arbeitet.

Die Schaltereinheit kann hierbei als Lenkwinkelsensor ausgebildet sein, wobei der Aktor auf einer Drehscheibe des Lenkwinkelsensors eines Fahrzeuges angeordnet ist und je nach Drehung der Scheibe in den Bereich von beeinflussbaren Widerständen gelangt, die auf der Umdrehungsbahn der Scheibe angeordnet sind. Je nach Drehung bzw. Drehposition der Scheibe werden von dem Aktor verschiedene Widerstände nacheinander oder auch zeitgleich beeinflusst. Diese Beeinflussung kann erfasst werden und ein Schaltsignal ausgewertet werden. Über eine derartige Schaltereinheit kann die Drehposition der Drehscheibe eindeutig und berührungslos erfasst werden.

Erfindungsgemäß ist auch denkbar, dass die Schaltereinheit als Lenkstockschalter ausgebildet ist und dass das Betätigungselement ein Schalthebel des Lenkstockschalters ist. Insbesondere Lenkstockschalter unterliegen einer sehr häufigen Betätigung. Schaltereinheiten mit bekannten Schleifkontakten neigen hierbei zum Verschleiß. Ein erfindungsgemäßer Lenkstockschalter unterliegt vorteilhafterweise keinem Verschleiß.

Die eingangs genannte Aufgabe wird auch durch ein Verfahren zur Erzeugung und Auswertung eines Schaltsignals gelöst, das sich durch folgende Verfahrensschritte kennzeichnet:
- Bewegen eines Aktors in den Umgebungsbereich eines berührungslos beeinflussbaren Widerstandes, wobei der Widerstand aufgrund der Beeinflussung seinen Widerstandswert ändert und ein Schaltsignal erzeugt, und
- Erfassung der Widerstandsänderung und Auswertung des Schaltsignals.

Über ein derartiges Verfahren kann ein Schaltsignal berührungslos erzeugt werden. Ein Verschleiß kann somit nicht auftreten.

Eine besonders vorteilhafte Weiterbildung des Verfahrens zeichnet sich dadurch aus, dass wenigstens zwei Widerstände vorhanden sind, dass einer der Widerstände als Referenzwiderstand und wenigstens ein weiterer Widerstand als von dem Aktor beeinflussbarer Widerstand ausgebildet ist, wobei die Auswerteeinheit durch Vergleich der Ausgangssignale des Referenzwiderstandes und des wenigstens einen beeinflussbaren Widerstandes ein Schaltsignal auswertet. Durch Vergleich der beiden Widerstände kann gewährleistet werden, dass ein Schaltsignal erfasst wird.

Vorteilhafterweise kann erfindungsgemäß auch ein Oszillator vorgesehen sein, der zwei parallel geschaltete beeinflussbare, frequenzabhängige Widerstände mit einem Oszillatorsignal beaufschlagt, wobei zwischen dem Oszillator und einem der beiden Widerstände das Oszillatorsignal invertiert wird, und wobei die Ausgangssignale der Widerstände addiert werden und das addierte Ausgangssignal ausgewertet wird. Vorzugsweise weisen hierbei die Widerstände identische Widerstandswertcharakteristiken auf, wobei bei unbeeinflussten Widerständen das addierte Ausgangssignal null und bei Beeinflussung von wenigstens einem Widerstand ungleich null ist. Hierdurch ist eine eindeutige Erfassung und Auswertung eines Schaltsignales möglich.

Weitere vorteilhafte Ausgestaltungen und Einzelheiten der Erfindung sind der folgenden Beschreibung zu entnehmen, in der die Erfindung anhand der in der Zeichnung dargestellten Ausführungsbeispiele näher beschrieben und erläutert ist.

Es zeigen:
- Figur 1: das Schaltschema einer erfindungsgemäßen Schalteinrichtung,
- Figur 2 und 3: eine erfindungsgemäße Schalteinrichtung in Form eines Lenkstockschalters und
- Figur 4 und 5: eine erfindungsgemäße Schalteinrichtung in Form eines Lenkwinkelsensors.

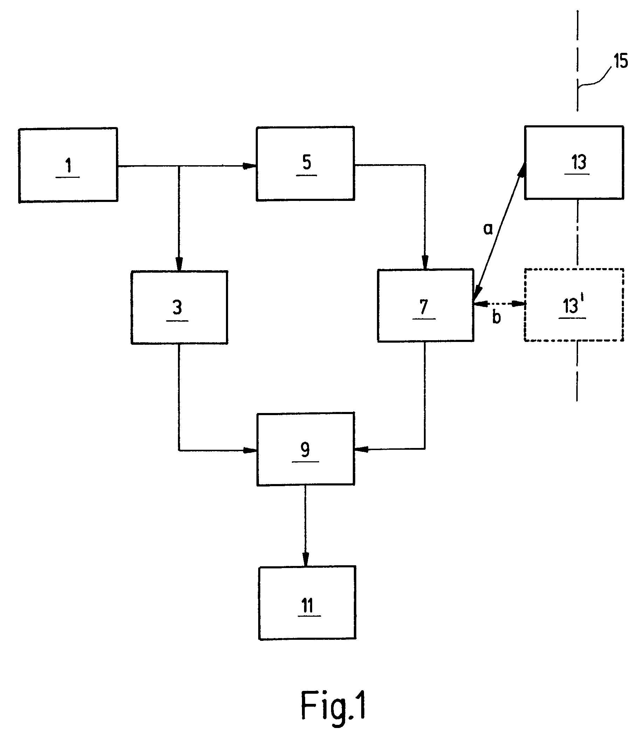

Das in Figur 1 dargestellte Schaltschema einer besonders bevorzugten Ausführungsform der Erfindung weist einen Oszillator 1 auf. Dem Oszillator 1 ist ein erster frequenzabhängiger Widerstand 3 als Referenzwiderstand nachgeschaltet. Parallel dazu ist dem Oszillator 1 ein Inverter 5 nachgeschaltet, der das von dem Oszillator 1 ausgehende Signal um 180° invertiert. Dem Inverter 5 ist wiederum ein zweiter frequenzabhängiger Widerstand 7 als beeinflussbarer Widerstand nachgeschaltet. Die Ausgangssignale der beiden Widerstände 3 und 7 werden von einem Addierer 9 addiert. Das Ausgangssignal des Addierers 9 wird einer Auswertelogik 11 zugeführt. Figur 1 zeigt weiterhin einen bewegbaren Aktor 13, der entlang der Linie 15 bewegt werden kann.

Bei der in Figur 1 gezeigten Ausführungsform der Erfindung ist der Widerstand 3 vorteilhafterweise identisch mit dem Widerstand 7. Die Widerstände 3 und 7 sind vorteilhafterweise frequenzabhängige, induktive Widerstände. Der Aktor 13 ist vorteilhafterweise als ferromagnetisches Metall ausgebildet.

Bei der in Figur 1 dargestellten Schaltposition weist der Aktor 13 den Abstand a zu dem Widerstand 7 auf. Der Aktor 13 ist hierbei noch nicht in den Umgebungsbereich des frequenzabhängigen Widerstandes 7 eingetreten, d.h. der Aktor 13 beeinflusst den Widerstand 7 noch nicht.

Wird der Aktor 13 allerdings in die in Figur 1 gestrichelt dargestellte Lage 13' geführt, so beträgt der Abstand zwischen dem Aktor 13 und dem Widerstand 7 den Wert b. Dieser Abstand liegt innerhalb des Umgebungsbereiches des Widerstands 7, innerhalb dessen der Widerstand 7 von dem Aktor beeinflusst wird.

Bei nicht beeinflusstem Widerstand 7 ist das Ausgangssignal des Addierers 9 null, da sich bei identischen Widerständen 3 und 7 die Ausgangssignale der Widerstände 3 und 7 aufgrund des invertierten Eingangssignales des Widerstandes 7 aufheben.

Wird allerdings der Aktor 13 in den Umgebungsbereich des Widerstandes 7 bzw. in die Position 13' geführt, so ändert der frequenzabhängige Widerstand 7 seinen Widerstandswert.

Aufgrund der Widerstandwertsänderung ist das addierte Ausgangssignal der beiden Widerstände 3 und 7 ungleich null. Die Auswertelogik 11 kann demnach auf einfache Art und Weise zwischen zwei Schaltstellungen differenzieren, nämlich zwischen der in welcher das Ausgangssignal des Addierers null ist und der bei welcher das Ausgangssignal des Addierers 9 ungleich null ist.

Besonderer Vorteil der in Figur 1 dargestellten Schalteinrichtung ist, dass sie keinem Verschleiß unterliegt. Der beeinflussbare Widerstand 7 wird von dem Aktor 13 beeinflusst, ohne dass der Aktor 13 den Widerstand 7 berührt.

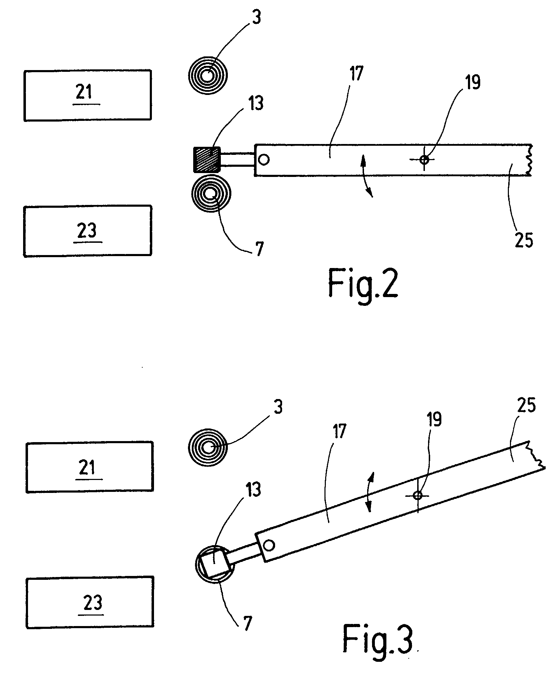

Die Figuren 2 und 3 zeigen zwei verschiedene Schaltstellungen eines Lenkstockschalters mit einer erfindungsgemäßen Schaltereinheit. Dazu zeigt Figur 2 einen Schalthebel 17, der um eine Achse 19 schwenkbar angeordnet ist. Der Schalthebel 17 weist an seinem in den Figuren 2 und 3 dargestellten freien Ende einen Aktor 13 auf. Weiterhin ist sowohl ein beeinflussbarer Widerstand 7 als auch ein Referenzwiderstand 3 in den Figuren 2 und 3 dargestellt. Die Figuren 2 und 3 zeigen außerdem beispielhaft je eine Ansteuerelektronik 21 als auch eine Auswerteelektronik 23.

Bei der in Figur 2 dargestellten Schaltposition beeinflusst der Aktor 13 den beeinflussbaren Widerstand 7 nicht. Wird allerdings der Schalthebel 17 von der in Figur 2 in die in Figur 3 dargestellte Schaltposition geschwenkt, so befindet er sich in dem Nahbereich des beeinflussbaren Widerstandes 7. Der beeinflussbare Widerstand 7 wird demnach von dem Aktor 13 beeinflusst. Aufgrund dieser Beeinflussung wird ein Schaltsignal gegeben, was von der Auswerteelektronik 23 ausgewertet wird.

Der Schalthebel 17 ist beispielsweise über ein Betätigungselement 25 betätigbar, dass auf der dem Aktor 13 abgewandten Seite des Schalthebels 17 angeordnet ist.

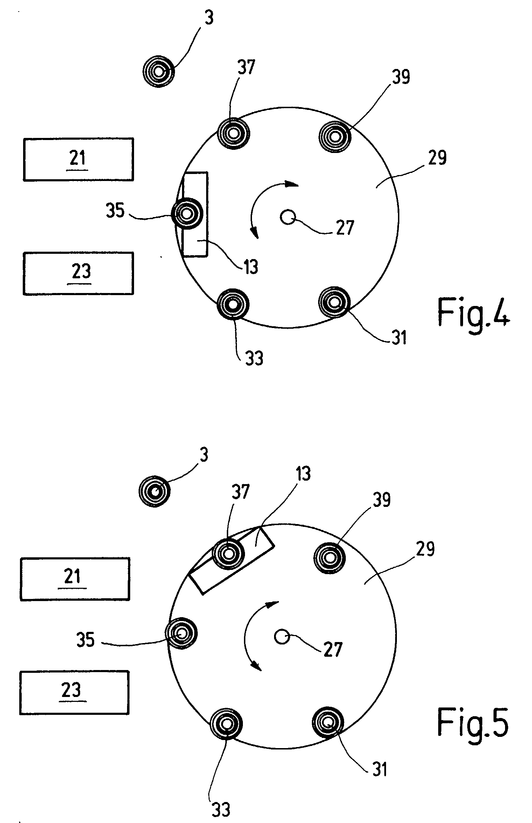

Eine weitere Ausführungsform der Erfindung ist in den Figuren 4 und 5 dargestellt. Der Aktor 13 ist hierbei auf einer um eine Achse 27 drehbaren Drehscheibe 29 angeordnet. Die Drehscheibe 29 ist hierbei Bestandteil eines Lenkwinkelsensors für ein Fahrzeug. Bei einem derartigen Lenkwinkelsensor ist die Drehachse 27 mit der Lenksäule einer Fahrzeuglenkung drehfest gekoppelt. Oberhalb der Drehscheibe 29 sind auf der Umdrehungsbahn der Drehscheibe 29 verschiedene beeinflussbare Widerstände 31, 33, 35, 37 und 39 angeordnet. Bei der Stellung der Drehscheibe gemäß Figur 4 wird der Widerstand 35 von dem Aktor 13 beeinflusst. Bei der Stellung gemäß Figur 5, bei der die Drehscheibe im Vergleich zu der Stellung gemäß Figur 4 etwas verdreht wurde, wird der Widerstand 37 von dem Aktor 13 beeinflusst.

Besonderer Vorteil der Ausführungsform gemäß Figur 4 und 5 ist, dass die Position der Drehscheibe 29 bzw. der damit gekoppelte Lenkwinkel eines Fahrzeuges berührungslos bestimmt werden kann. Ein ensprechendes Schaltsignal wird von dem berührungslos beeinflussbaren Widerstand 31 - 39 erzeugt und von der Auswerteelektronik 23 ausgewertet.

Alle in der Beschreibung, den nachfolgenden Ansprüchen und der Zeichnung dargestellten Merkmale können sowohl einzeln als auch in beliebiger Kombination miteinander erfindungswesentlich sein.

## Patentansprüche

1. Schalteinrichtung zur Erzeugung und Auswertung eines Schaltsignals, **dadurch gekennzeichnet,**
**dass** die Einrichtung wenigstens einen berührungslos beeinflussbaren, aufgrund der Beeinflussung seinen Widerstandswert ändernden Widerstand (7, 31 - 39), einen in den Umgebungsbereich des Widerstandes (7, 31 - 39) bewegbaren und damit den Widerstand (7, 31 - 39) beeinflussenden Aktor (13) sowie eine dem Widerstand (7, 31 - 39) nachgeschaltete, den Widerstandswert erfassende Auswerteeinheit (9, 11, 23) aufweist, wobei durch Bewegen des Aktors (13) in den Umgebungsbereich des Widerstandes (7, 31 - 39) der Widerstand (7, 31 - 39) seinen Widerstandswert ändert und die Auswerteeinheit (9, 11, 23) die Widerstandswertänderung auswertet.

2. Schalteinrichtung nach Anspruch 1, **dadurch gekennzeichnet, dass** wenigstens zwei Widerstände (3, 7, 31 - 39) vorhanden sind, dass einer der Widerstände (3) als Referenzwiderstand und wenigstens ein weiterer Widerstand (7, 31 - 39) als von dem Aktor (13) beeinflussbarer Widerstand (7, 31 - 39) ausgebildet ist, wobei die Auswerteeinheit (9, 11, 23) durch Vergleich der Ausgangssignale des Referenzwiderstandes (3) und des wenigstens einen beeinflussbaren Widerstandes (7, 31 - 39) ein Schaltsignal auswertet.

3. Schalteinrichtung nach Anspruch 1 oder 2, **dadurch gekennzeichnet, dass** der wenigstens eine beeinflussbare Widerstand ein mit Wechselstrom beaufschlagter frequenzabhängiger Widerstand (7, 31 - 39) ist.

4. Schalteinrichtung nach Anspruch 3, **dadurch gekennzeichnet, dass** ein Oszillator (1), ein dem Oszillator (1) nachgeschalteter erster frequenzabhängiger Widerstand (Referenzwiderstand 3) und ein dem Oszillator (1) nachgeschalteter, zu dem ersten Widerstand (3) parallel angeordneter Inverter (5) vorgesehen ist, wobei dem Inverter (5) ein zweiter frequenzabhängiger Widerstand (beeinflussbarer Widerstand 7) nachgeschaltet ist, dass dem ersten Widerstand (3) und dem zweiten Widerstand (7) ein Addierer (9), der die Ausgangssignale der beiden Widerstände (3, 7) addiert, und eine Auswertelogik (11), die aufgrund eines sich ändernden Ausgangssignals des Addierers (9) aufgrund der kontaktlosen Beeinflussung eines der beiden Widerstände (3, 7) durch den Aktor (13) ein Schaltsignal auswertet, nachgeschaltet ist.

5. Schalteinrichtung nach Anspruch 4, **dadurch gekennzeichnet, dass** der wenigstens eine frequenzabhängige Widerstand (7, 31 - 39) ein induktiver Widerstand ist und dass der Aktor (13) ein ferromagnetisches Metall ist.

6. Schalteinrichtung nach Anspruch 4, **dadurch gekennzeichnet, dass** der wenigstens eine frequenzabhängige Widerstand (7, 31 - 39) ein kapazitiver Widerstand ist und dass der Aktor (13) ein Isolator mit insbesondere einer hohen Permittivitätszahl (∈ᵣ ca. 3 oder höher) ist.

7. Schalteinrichtung nach Anspruch 4, 5 oder 6, **dadurch gekennzeichnet, dass** die Widerstände (3, 7, 31 - 39) eine identische Widerstandswertcharakteristik aufweisen, wobei bei unbeeinflusstem Widerstand (3, 31 - 39) das Ausgangssignal des Addierers (9) null und bei Beeinflussung von wenigstens einem Widerstand (7, 31 - 39) ungleich null ist.

8. Schalteinrichtung nach einem der vorhergehenden Ansprüche, **dadurch gekennzeichnet, dass** mehrere unterschiedliche, verschiedenen Schaltsignalen zuordenbare Aktoren vorhanden sind, welche den Widerstandswert des beeinflussbaren Widerstands unterschiedlich ändern, wobei die Auswerteeinheit aufgrund der jeweiligen Widerstandsänderung feststellt durch welchen Aktor die Widerstandsänderung erfolgte und die unterschiedlichen Schaltsignale auswertet.

9. Schaltereinheit nach einem der vorhergehenden Ansprüche, **dadurch gekennzeichnet, dass** die Schaltereinheit ein Betätigungselement (25, 29) aufweist, das mittel- oder unmittelbar den Aktor (13) bewegt.

10. Schaltereinheit nach einem der vorhergehenden Ansprüche, **dadurch gekennzeichnet, dass** die Schaltereinheit eine die Widerstände (3, 7, 31 - 39) tragende Leiterplatine aufweist.

11. Schaltereinheit nach einem der vorhergehenden Ansprüche, **dadurch gekennzeichnet, dass** die Schaltereinheit als Fahrzeugschalter ausgebildet ist.

12. Schaltereinheit nach Anspruch 11, **dadurch gekennzeichnet, dass** der Aktor auf einer Drehscheibe (29) eines Lenkwinkelsensors eines Fahrzeuges angeordnet ist und in den Bereich von beeinflussbaren Widerständen (31 - 39) gelangt, die auf der Umdrehungsbahn der Scheibe (29) angeordnet sind.

13. Schaltereinheit nach Anspruch 11, **dadurch gekennzeichnet, dass** die Schaltereinheit als Lenkstockschalter ausgebildet ist und dass das Betätigungselement (25) ein Schalthebel (17) des Lenkstockschalters ist.

14. Verfahren zur Erzeugung und Auswertung eines Schaltsignals, **gekennzeichnet durch** folgende Verfahrensschritte:
- Bewegen eines Aktors (13) in den Umgebungsbereich eines berührungslos beeinflussbaren Widerstandes (7, 31- 39), wobei der Widerstand (7, 31 - 39) aufgrund der Beeinflussung seinen Widerstandswert ändert und ein Schaltsignal erzeugt, und
- Erfassung der Widerstandswertänderung und Auswertung des Schaltsignals.

15. Verfahren nach Anspruch 14, **dadurch gekennzeichnet, dass** wenigstens zwei Widerstände (3, 7, 31 - 39) vorhanden sind, dass einer der Widerstände als Referenzwiderstand (3) und wenigstens ein weiterer Widerstand (7, 31 - 39) als von dem Aktor (13) beeinflussbarer Widerstand (7, 31 - 39) ausgebildet ist, wobei die Auswerteeinheit (9, 11, 23) durch Vergleich der Ausgangssignale des Referenzwiderstandes (3) und des wenigstens einen beeinflussbaren Widerstandes (7, 31 - 39) ein Schaltsignal auswertet.

16. Verfahren nach Anspruch 14 oder 15, **dadurch gekennzeichnet, dass** ein Oszillator (1) zwei parallel geschaltete beeinflussbare, frequenzabhängige Widerstände (3, 7, 31 - 39) mit einem Oszillatorsignal beaufschlagt, wobei zwischen dem Oszillator (1) und einem der beiden Widerstände (3, 7, 31 - 39) das Oszillatorsignal invertiert wird, und wobei die Ausgangssignale der Widerstände (3, 7) addiert werden und das addierte Ausgangssignal ausgewertet wird.

17. Schalteinrichtung nach Anspruch 14, 15 oder 16, **dadurch gekennzeichnet, dass** die Widerstände (3, 7, 31 - 39) eine identische Widerstandswertcharakteristik aufweisen, wobei bei unbeeinflussten Widerständen (3, 7, 31 - 39) das addierte Ausgangssignal null und bei Beeinflussung von wenigstens einem Widerstand (7, 31 - 39) ungleich null ist.
